# FASCICULE DE BREVET EUROPEEN

(11) **EP 2 966 949 B1**
(45) Date de publication et mention de la délivrance du brevet: **13.06.2018**
(21) Numéro de dépôt: 15175901.6
(22) Date de dépôt: 08.07.2015
(51) Int. Cl.: H05K 5/02, G01R 1/04

(54) **APPAREIL ÉLECTRIQUE COMPORTANT UN BOÎTIER FERMÉ PAR UN CAPOT**
ELEKTROGERÄT, DAS EIN MIT EINER HAUBE VERSCHLIESSBARES GEHÄUSE UMFASST
ELECTRICAL APPLIANCE COMPRISING A HOUSING CLOSED BY A COVER

(30) Priorité: 09.07.2014 FR 1456636
(43) Date de publication de la demande: 13.01.2016
(73) Titulaire: SAGEMCOM ENERGY & TELECOM SAS, 92500 Rueil-Malmaison (FR)
(72) Inventeur: ROLLAND, Patrick, 92500 Rueil Malmaison (FR)
(74) Mandataire: Lavialle, Bruno François Stéphane

(56) Documents cités:
- EP-A1- 0 930 813
- EP-A1- 1 731 914
- DE-A1- 3 933 644
- DE-A1-102005 009 111
- GB-A- 2 431 244
- US-A1- 2011 032 664
- US-A1- 2011 116 216
- US-A1- 2011 239 418

## Description

L'invention concerne la fixation de capots sur des boîtiers d'appareils électriques, et notamment sur des boîtiers de compteurs électriques.

### ARRIERE PLAN DE L'INVENTION

De très nombreux appareils électriques comportent un boîtier dans lequel sont intégrés des composants électriques, ledit boîtier étant fermé par un capot protégeant l'intérieur du boîtier.

Ainsi, un compteur électrique comporte classiquement un boîtier adapté à être fixé sur un mur d'une habitation, un ensemble de composants électriques montés sur au moins une carte électrique installée dans le boîtier et destinés à mesurer la consommation électrique de l'habitation, à afficher et à transmettre les mesures, ainsi qu'un capot monté sur le boîtier pour masquer et protéger ces composants électriques.

De multiples contraintes techniques et économiques guident la fabrication du boîtier et du capot d'un tel compteur électrique.

Parmi les contraintes techniques, on trouve notamment des contraintes de conception mécanique associées au design mécanique du boîtier et du capot.

Ces contraintes de conception mécanique peuvent être des contraintes très générales, applicables à la plupart des compteurs électriques. Ainsi, les fournisseurs d'énergie électrique requièrent fréquemment que le boîtier d'un compteur électrique soit dimensionné pour intégrer un nombre relativement important de composants électriques tout en présentant une enveloppe externe de volume réduit. Un capot destiné à fermer un tel boîtier doit donc être conçu de manière à ce que des moyens de fixation associés au capot utilisent un volume très réduit à l'intérieur du boîtier.

Ces contraintes de conception mécanique peuvent aussi être propres à certains compteurs électriques. Ainsi, il est parfois requis que le boîtier du compteur comprenne une ouverture permettant d'accéder à certains composants à l'intérieur du boîtier. Le capot doit être conçu pour protéger cette ouverture lorsqu'il est monté sur le boîtier.

Parmi les contraintes économiques, on trouve bien sûr le coût de développement et le coût de fabrication en série du boîtier et du compteur, qui doivent être aussi bas que possible. On trouve aussi les coûts de la logistique et de l'impact carbone liés au transport du boîtier et du capot, qui doivent, une fois encore, être réduits au maximum. Une réduction de ces coûts nécessite un compactage optimum des pièces à transporter depuis leur lieu de fabrication jusqu'au lieu d'assemblage du compteur.

Ces différentes contraintes se retrouvent dans de nombreux appareils électriques.

Le document GB2431244 décrit un appareil électrique comportant un boîtier et un capot encliqueté au boîtier.

### OBJET DE L'INVENTION

L'invention a pour objet un appareil électrique qui réponde aux contraintes de conception mécanique et économiques évoquées plus tôt.

### RESUME DE L'INVENTION

En vue de la réalisation de ce but, on propose, selon l'invention, un appareil électrique selon la revendication 1. L'appareil électrique de l'invention comporte donc un boîtier comprenant une ouverture d'accès qui permet d'accéder à des composants électriques intégrés dans le boîtier notamment pour effectuer des raccordements de service si nécessaire. Cette ouverture d'accès est fermée par le capot secondaire qui protège ces composantes électriques lorsque le capot principal ferme le boîtier. Comme le capot secondaire est encliqueté par des moyens d'encliquetage agencés dans une épaisseur du capot secondaire, ces moyens d'encliquetage occupent un volume presque nul à l'intérieur du boîtier, ce qui permet d'optimiser l'intégration des composants électriques dans le boîtier.

On note que le coût de l'encliquetage du capot secondaire sur le capot principal est très faible. Cette manière de fixer le capot secondaire sur le capot principal ne requiert aucune opération de montage complexe et onéreuse, comme par exemple une opération de soudage par ultrasons, de bouterollage, de collage, d'injection bi-matière si les capots sont de couleurs différentes, etc.

L'utilisation d'un capot principal et d'un capot secondaire permet de transporter ces capots à plat et donc en très grande quantité dans un volume de transport donné : on réduit ainsi de manière importante les coûts et l'impact carbone associés au transport de ces capots.

L'invention sera mieux comprise à la lumière de la description qui suit d'un mode de mise en oeuvre particulier non limitatif de l'invention.

### BREVE DESCRIPTION DES DESSINS

Il sera fait référence aux dessins annexés, parmi lesquels :
- la figure 1 est une vue en perspective (vue depuis le dessous) d'un appareil électrique de l'invention, en l'occurrence d'un compteur électrique, comportant un boîtier et un capot principal fermant le boîtier ;
- la figure 2 est une vue analogue à celle de la figure 1, dans laquelle le capot principal est éloigné du boîtier ;
- les figures 3 et 4 sont des vues de détail en perspective du capot principal et d'un capot secondaire du compteur électrique, lesdites vues représentant plus particulièrement des moyens d'encliquetage permettant d'encliqueter le capot secondaire au capot principal.

### DESCRIPTION DETAILLEE DE L'INVENTION

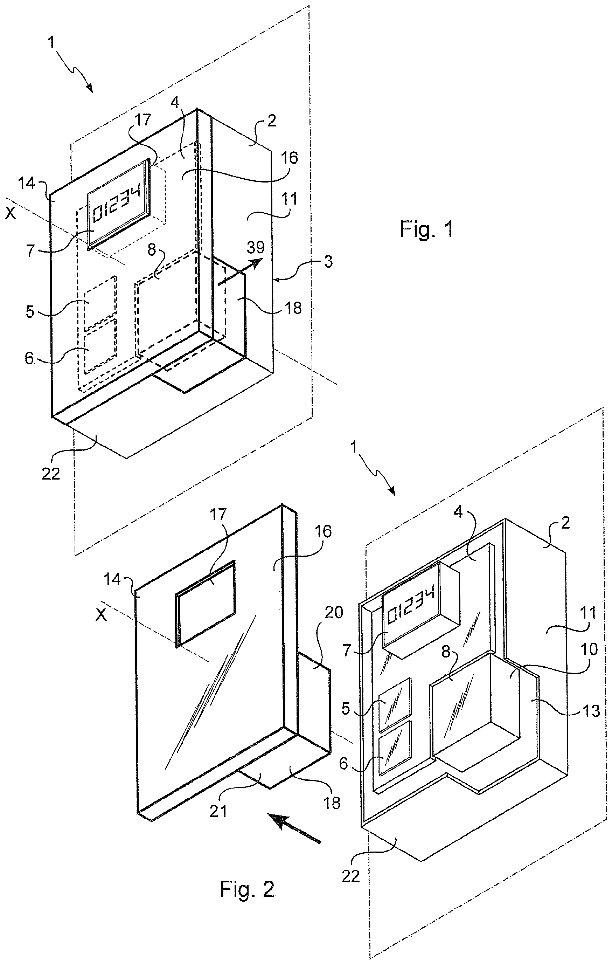

En référence aux figures 1 et 2, l'appareil électrique utilisé dans cette description pour illustrer l'invention est un compteur électrique 1 de forme extérieure générale parallélépipédique. Le compteur électrique 1 comprend un boîtier 2 comportant une face arrière 3 fixée au mur d'une habitation par des moyens de fixation classiques et non décrits ici.

Ce compteur électrique 1 est un compteur du type communément appelé « électronique », adapté notamment à mesurer une consommation électrique de l'habitation, à afficher les données de consommation mesurées, et à transmettre ces données via une transmission sans fil.

Les fonctions de mesure et d'affichage sont réalisées par des composants électriques montés sur une carte électrique 4 intégrée à l'intérieur du boîtier 2 du compteur électrique 1. Ces composants électriques comprennent notamment des composants de mesure 5 mesurant la consommation électrique, des composants de traitement 6 destinés à traiter les mesures de consommation et à gérer le fonctionnement du compteur électrique, et un afficheur 7 de type LCD.

La fonction de transmission sans fil, quant à elle, est réalisée par un module de communication 8 adapté à transmettre les données de consommation mesurées. Le module de communication 8 est un module amovible, optionnel, qui n'est pas monté sur la carte électrique 4 mais qui est installé dans un logement latéral 10 situé à proximité immédiate d'une face latérale 11 du compteur électrique 1. Le module électrique 8 est cependant relié électriquement aux composants de traitement 6 de la carte électrique 4 pour acquérir les données de consommation mesurées de manière à pouvoir les transmettre.

Pour permettre un accès au module de communication 8, dans le but d'installer ou de retirer le module de communication 8, ou bien de réaliser une opération quelconque sur le module de communication 8 (chargement de données, vérification de l'état du module de communication, etc.), le boîtier 2 comprend une ouverture d'accès latéral 13.

Le compteur électrique 1 comporte un capot principal 14 destiné à fermer le boîtier 2 pour protéger et masquer la carte électrique 4, les composants électriques et le module de communication 8 évoqués plus tôt. Le capot principal 14 est adapté à être engagé sur le boîtier 2 (ou désengagé du boîtier) selon une direction X normale au capot principal 14. Par « direction normale », on entend une direction normale à une partie plane principale 16 du capot principal 14 disposée sensiblement parallèlement à la face arrière 3 du boîtier 2 lorsque le capot principal 14 ferme le boîtier 2. La partie plane principale 16 du capot principal 14 est munie d'une ouverture 17 destinée à rendre visible l'afficheur 7.

Le compteur électrique 1 comporte de plus un capot secondaire 18 amovible fixé au capot principal 14, dont le rôle est de fermer l'ouverture d'accès latéral 13 qui permet d'accéder au module de communication 8. Par « amovible », on entend que le capot secondaire 18 peut être désolidarisé du capot principal 14.

Le capot secondaire 18 comporte une première paroi latérale 20 fermant l'ouverture d'accès latéral 13 et une deuxième paroi 21 s'étendant perpendiculairement à la première paroi 20 et fermant le boîtier 2 au niveau d'une face inférieure 22 du compteur électrique 1.

On décrit désormais plus en détail l'interface mécanique entre le capot principal 14 et le capot secondaire 18, et les moyens de fixation permettant de fixer le capot secondaire 18 au capot principal 14.

Les moyens de fixation sont des moyens d'encliquetage qui permettent d'encliqueter le capot secondaire 18 au capot principal 14 selon la direction normale au capot principal. On utilise le terme « encliquetage » pour désigner un engagement élastique d'une pièce dans une autre.

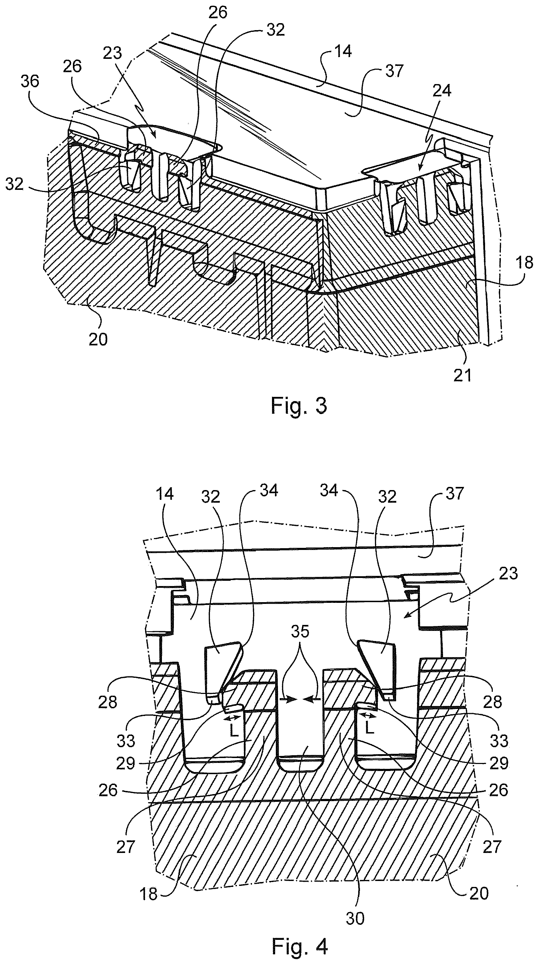

En référence aux figures 3 et 4, les moyens d'encliquetage comprennent des premiers moyens d'encliquetage 23 pour encliqueter au capot principal 14 la première paroi 20 du capot secondaire 18 et des deuxièmes moyens d'encliquetage 24 pour encliqueter au capot principal 14 la deuxième paroi 21 du capot secondaire 18. Les premiers moyens d'encliquetage 23 et les deuxièmes moyens d'encliquetage 24 sont donc disposés dans deux plans perpendiculaires. Les premiers moyens d'encliquetage 23 et les deuxièmes moyens d'encliquetage 24 agissent simultanément lorsque le capot secondaire 18 est encliqueté au capot principal 14.

On décrit ici uniquement les premiers moyens d'encliquetage 23, les deuxièmes moyens d'encliquetage 24 étant en tout point semblables aux premiers moyens d'encliquetage 23.

Les premiers moyens d'encliquetage 23 comprennent deux pattes d'accrochage flexibles 26 réalisées dans l'épaisseur de la première paroi 20 du capot secondaire 18. Ces deux pattes d'accrochage flexibles 26 présentent chacune une partie courante longitudinale 27 et une extrémité libre munie d'un crochet 28. Les deux parties courantes longitudinales 27 s'étendent parallèlement l'une par rapport à l'autre. Chaque crochet 28 possède une zone d'accrochage 29 qui s'étend vers l'extérieur d'un espace central 30 délimitée par les deux parties longitudinales 27 des pattes d'accrochage 26.

Les premiers moyens d'encliquetage 23 comprennent en outre deux saillies d'accrochage 32 situées sur un rebord du capot principal 14 destiné à s'étendre parallèlement à la première paroi 20, chaque saillie d'accrochage 32 comprenant une extrémité de contact 33 et une extrémité de fixation 34. Lorsque le capot secondaire 18 est encliqueté au capot principal 14, les saillies d'accrochage 32 s'étendent elles aussi dans l'épaisseur de la première paroi 20 du capot secondaire 18.

Lorsque le capot secondaire 18 est engagé dans le capot principal 14 selon la direction normale X au capot principal 14, les pattes d'accrochage 26 fléchissent au contact des extrémités de contact 33 des saillies d'accrochage 32 vers l'intérieur de l'espace central 30, ledit fléchissement étant représenté sur la figure 3 par les flèches 35. Ce fléchissement permet d'engager les crochets 28 des pattes d'accrochage 26 entre les saillies d'accrochage 32, de sorte que les zones d'accrochage 29 des cochets 28 coopèrent par complémentarité de forme avec les extrémités de fixation 34 des saillies d'accrochage 32 pour emprisonner les pattes d'accrochage 26 entre les saillies d'accrochage 32. La première paroi 20 du capot secondaire 18 est ainsi encliquetée au capot principal 14.

La deuxième paroi 21 du capot secondaire 18 est encliquetée de la même manière (et simultanément) au capot principal 14.

Lorsque le capot secondaire 18 est encliqueté au capot principal 14, les parties de la première paroi 20 et de la deuxième paroi 21 du capot secondaire 18 qui ne sont pas munies de pattes d'accrochage 26 sont accueillies dans une gorge d'accueil 36 pratiquée à cet effet dans un fond 37 du capot principal 14.

On définit une force d'encliquetage comme étant une force qu'il convient d'appliquer selon la direction normale X au capot principal 14 pour engager le capot secondaire 18 au capot principal 14. En référence à la figure 4, la force d'encliquetage peut être réglée, au moment de la fabrication du capot secondaire, en modifiant la longueur L de la zone d'accrochage 29 des crochets 28 des pattes de fixation 26.

On observe que les moyens d'encliquetage occupent un volume presque nul à l'intérieur du boîtier 2, ce qui permet d'optimiser l'intégration du module de communication 8 dans le logement latéral 10.

On observe aussi que la structure particulière des pattes d'accrochage 26 et des saillies d'accrochage 32 et la manière dont les pattes 26 et les saillies 32 coopèrent mécaniquement permettent d'éviter un décliquetage accidentel lorsque force perpendiculaire à la direction normale X au capot principal 14, représentée par la flèche 39 sur la figure 1, est appliquée au capot secondaire 18.

Enfin, on note que les saillies d'accrochage 32 forment des pièces qui, au cours d'une fabrication par moulage du capot principal 14, tendent à s'opposer au démoulage du capot principal 14. Il est donc préférable, pour fabriquer par moulage le capot principal 14, d'utiliser un moule à tiroir qui permet de résoudre la difficulté précitée.

Le montage du capot principal 14 et du capot secondaire 18 sur le boîtier 2 est effectué de la façon suivante. Le capot secondaire 18 est tout d'abord positionné sur le boitier 2 grâce à des moyens de positionnement du capot secondaire 18 sur le boîtier 2. Puis, le capot principal 14 est encliqueté à la fois sur le boîtier 2 et sur le capot secondaire 18 (de la façon décrite plus tôt). Lors du retrait du capot principal 14, le capot secondaire 18 reste solidaire du capot principal 14. L'invention permet un montage irréversible des deux pièces rendant leur désolidarisation impossible.

L'invention n'est pas limitée au mode de mise en oeuvre particulier qui vient d'être décrit, mais, bien au contraire, couvre toute variante entrant dans le cadre de l'invention telle que défini par les revendications.

Bien que l'on ait ici illustré l'invention en utilisant un compteur électrique, celle-ci s'applique à tout appareil électrique comprenant un boîtier et un capot destiné à fermer ce boîtier.

Bien que l'on ait indiqué que l'ouverture d'accès du boîtier est une ouverture d'accès latéral, cette ouverture peut être située au niveau de chacune des faces du compteur, à l'exception toutefois de la face fermée par le capot principal.

## Revendications

1. Appareil électrique comportant un boîtier (2), un capot principal (14) fermant le boîtier (2), et un capot secondaire (18) fermant un ouverture d'accès latéral (13) du boîtier (2), l'appareil électrique permettant permet par des moyens d'encliquetage (23, 24) d'encliqueter le capot secondaire (18) au capot principal (14) selon une direction normale (X) au fond (37) du capot principal (14), le fond (37) du capot principal (14), dans lequel est pratiquée une gorge d'accueil (36), comporte un rebord pourvu de saillies d'accrochage (32) et au moins une paroi (20, 21) du capot secondaire (18) comprend des pattes d'accrochage flexibles (26) qui s'étendent dans son épaisseur (36).

2. Appareil électrique selon la revendication 1, dans lequel le capot secondaire (18) comporte une première paroi latérale (20) fermant l'ouverture d'accès (13) et une deuxième paroi (21) s'étendant perpendiculairement à la première paroi (20).

3. Appareil électrique selon la revendication 2, dans lequel les moyens d'encliquetage comprennent des premiers moyens d'encliquetage (23) pour encliqueter au capot principal (14) la première paroi du capot secondaire et des deuxièmes moyens d'encliquetage (24) pour encliqueter au capot principal la deuxième paroi du capot secondaire.

4. Appareil électrique selon la revendication 1, dans lequel chaque patte d'accrochage (26) est munie à une extrémité libre d'un crochet (28) s'étendant dans le plan de la paroi et coopérant via une zone d'accrochage (29) avec une saillie d'accrochage (32).

5. Appareil électrique selon la revendication 4, dans lequel une modification d'une longueur (L) de la zone d'accrochage (29) permet de modifier une force d'encliquetage.

6. Appareil électrique selon l'une des revendications précédentes, l'appareil électrique étant un compteur électrique (1) comportant un module de communication (8) située dans un logement latéral (10) et accessible via l'ouverture d'accès (13).

## Patentansprüche

1. Elektrogerät, das ein Gehäuse (2) umfasst, eine Hauptabdeckung (14), die das Gehäuse (2) verschließt, und eine Nebenabdeckung (18), die eine seitliche Zugangsöffnung (13) des Gehäuses (2) verschließt, wobei das Elektrogerät mittels Rastmittel (23, 24) ein Einrasten der Nebenabdeckung (18) an der Hauptabdeckung (14) in einer Richtung (X) senkrecht zum Boden (37) der Hauptabdeckung (14) ermöglicht, wobei der Boden (37) der Hauptabdeckung (14), in dem eine Aufnahmenut (36) ausgebildet ist, einen Rand umfasst, der mit Befestigungsvorsprüngen (32) versehen ist, und mindestens eine Wand (20, 21) der Nebenabdeckung (18) flexible Befestigungslaschen (26) umfasst, die sich in der Dicke der Wand erstrecken.

2. Elektrogerät nach Anspruch 1, bei dem die Nebenabdeckung (18) eine erste Seitenwand (20) umfasst, die die Zugangsöffnung (13) verschließt, und eine zweite Wand (21), die sich senkrecht zur ersten Wand (20) erstreckt.

3. Elektrogerät nach Anspruch 2, bei dem die Rastmittel erste Rastmittel (23) umfassen, um die erste Wand der Nebenabdeckung an der Hauptabdeckung (14) einzurasten, und zweite Rastmittel (24), um die zweite Wand der Nebenabdeckung an der Hauptabdeckung einzurasten.

4. Elektrogerät nach Anspruch 1, bei dem jede Befestigungslasche (26) an einem freien Ende mit einem Haken (28) versehen ist, der sich in der Ebene der Wand erstreckt und über eine Befestigungszone (29) mit einem Befestigungsvorsprung (32) zusammenwirkt.

5. Elektrogerät nach Anspruch 4, bei dem eine Veränderung einer Länge (L) der Befestigungszone ein Verändern einer Einrastkraft ermöglicht.

6. Elektrogerät nach einem der vorhergehenden Ansprüche, wobei das Elektrogerät ein elektrischer Zähler (1) ist, der ein Kommunikationsmodul (8) umfasst, das sich in einer seitlichen Aufnahme (10) befindet und über die Zugangsöffnung (13) zugänglich ist.

## Claims

1. Electrical appliance comprising a housing (2), a main cover (14) closing the housing (2), and a second cover (18) closing a lateral opening (13) of the housing (2), the electrical appliance allowing by latching means to latch the second cover to the main cover (14) in a normal direction (X) to the bottom (37) of the main cover (14), the bottom (37) of the main cover (14), in which a receiving groove (36) is formed, has a flange provided with hooking protrusions (32) and at least one wall (20, 21) of the second cover (18) comprises flexible fastening tabs (26) which extend in its thickness (36).

2. Electrical appliance according to claim 1, wherein the second cover (18) comprises a first side wall (20) closing the opening (13) and a second side wall (21) extending perpendicularly to the first wall (20).

3. Electrical appliance according to claim 2, wherein the latching means comprises first latching means (23) for latching the first wall of the second cover to the main cover (14) and second latching means (24) for latching the second wall of the second cover to the main cover (14).

4. Electrical appliance according to claim 1, wherein each fastening tab (26) is provided at a free end thereof with a hook (28) extending in the plane of the interior wall and cooperating via a latching region (29) with a hooking protrusion (32).

5. Electrical appliance according to Claim 4, wherein a change in a length (L) of the latching region (29) changes a latching force.

6. Electrical appliance according to one of the preceding claims, the electrical appliance being an electricity meter (1) comprising a communication module (8) situated in a lateral recess (10) and accessible via the opening (13).
